# EUROPEAN PATENT APPLICATION

(11) **EP 4 283 667 A1**
(43) Date of publication of application: **29.11.2023**
(21) Application number: 21927306.7
(22) Date of filing: 26.02.2021
(51) Int. Cl.: H01L 23/373, H01L 29/778, H01L 21/335

(54) **SEMICONDUCTOR DEVICE, ELECTRONIC APPARATUS, AND PREPARATION METHOD FOR SEMICONDUCTOR DEVICE**

(71) Applicant: Huawei Technologies Co., Ltd., Shenzhen, Guangdong 518129 (CN)
(72) Inventor: LI, Shuiming, Shenzhen, Guangdong 518129 (CN); WANG, Yu, Shenzhen, Guangdong 518129 (CN); MA, Ping, Shenzhen, Guangdong 518129 (CN); LU, Ming, Shenzhen, Guangdong 518129 (CN); TANG, Cen, Shenzhen, Guangdong 518129 (CN); ZHANG, Zhili, Shenzhen, Guangdong 518129 (CN); HE, Qiang, Shenzhen, Guangdong 518129 (CN); LI, Haijun, Shenzhen, Guangdong 518129 (CN); LIU, Tao, Shenzhen, Guangdong 518129 (CN); RAO, Jin, Shenzhen, Guangdong 518129 (CN)
(74) Representative: Pfenning, Meinig & Partner mbB
(86) International application number: PCT/CN2021/078280
(87) International publication number: WO 2022/178870

(57) **Abstract**

Embodiments of this application provide a semiconductor device, an electronic device, and a semiconductor device preparation method, and relate to the field of chip manufacturing and packaging technologies, to improve heat dissipation efficiency of the semiconductor device without increasing a size. The semiconductor device includes: a substrate, a source, a drain, a gate, and a groove. The source, the drain, and the gate are all formed on the substrate, and an active region is formed between the source and the drain on the substrate. The groove is disposed in the substrate, and a spacing is formed between the groove and the active region. A heat dissipation layer is formed in the groove, and a coefficient of thermal conductivity of the heat dissipation layer is greater than that of the substrate. This semiconductor structure can ensure that a device with a high power density also has a good heat dissipation effect.

## Description

### TECHNICAL FIELD

This application relates to the field of semiconductor device heat dissipation technologies, and in particular, to a semiconductor device, an electronic device, and a semiconductor device preparation method that can improve heat dissipation efficiency.

### BACKGROUND

A radio frequency device manufactured based on a compound semiconductor material, for example, a gallium nitride (Gallium Nitride, GaN)-based high electron mobility transistor (High Electron Mobility Transistor, HEMT), has characteristics of high breakdown voltage and high electron mobility, and is widely used in the fields of high-power radio frequency devices and high-voltage-resistant switch devices.

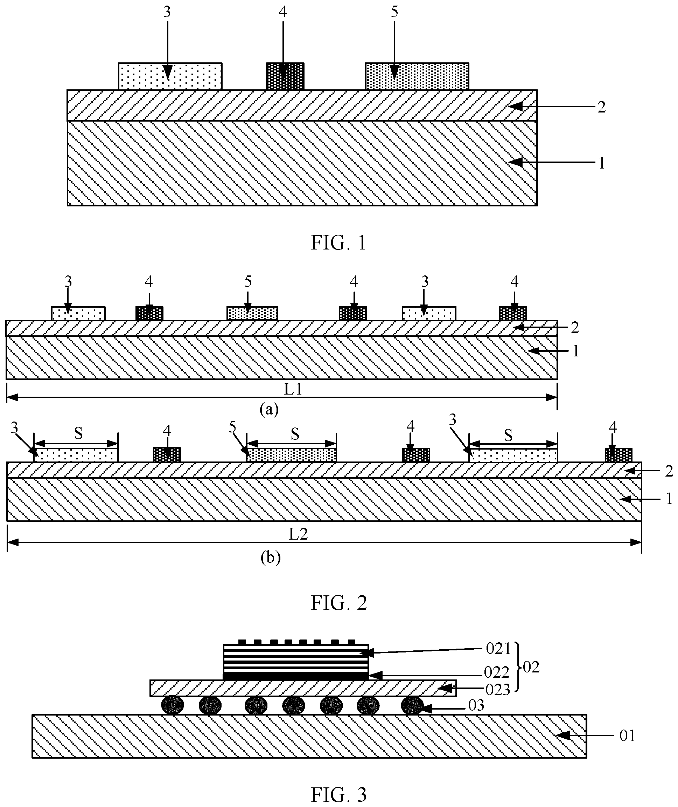

FIG. 1 is a structural diagram of a GaN-based HEMT, and the HEMT includes: a substrate 1, an epitaxial layer 2 disposed on the substrate 1, and a source 3, a gate 4, and a drain 5 disposed on the epitaxial layer 2. The epitaxial layer 2 is a multi-layer AlxGayN structure, where 0≤x≤1, and 0≤y≤1.

For example, in the GaN-based HEMT in FIG. 1, due to a high breakdown field strength characteristic of the GaN, the GaN-based HEMT is inevitably operated in a high voltage environment to obtain a higher power density. In addition, the high power density causes these HEMTs to generate much heat. If the heat cannot be dissipated in time, radio frequency performance, such as power and efficiency, of the device is seriously affected.

In the HEMT, a region of the epitaxial layer 2 between the source 3 and the drain 5 forms an active region. In this way, when a high current on the drain 5 flows to the source 3 through the epitaxial layer 2, the active region generates much heat and becomes a heat source region.

FIG. 2 is a common solution currently used for heat dissipation of an active region in the HEMT. It can be learned from comparison between (a) and (b) in FIG. 2 that, in the heat dissipation solution, the area of the heat dissipation region is increased by increasing width sizes of the source 3 and the drain 5 (size S in FIG. 2), to improve the heat diffusion efficiency.

With reference to FIG. 2, because there are design requirements for a spacing between the source 3 and the gate 4 and a spacing between the drain 5 and the gate 4, when the width sizes (size S in FIG. 2) of the source 3 and the drain 5 are increased, a size of an entire HEMT is significantly increased (for example, L1 in FIG. 2 is increased to L2). In this way, a quantity of HEMTs that can be generated on a single wafer is reduced. In addition, because the size of the HEMT becomes larger, non-uniformity of a size of the epitaxial layer or the electrode (for example, the source 3 and the drain 5) is amplified, and the performance of the HEMT may potentially deteriorate.

### SUMMARY

Embodiments of this application provide a semiconductor device, an electronic device, and a semiconductor device preparation method, to provide a semiconductor device that can improve heat dissipation efficiency.

To achieve the foregoing objectives, the following technical solutions are used in embodiments of this application.

According to a first aspect, this application provides a semiconductor device, where the semiconductor device includes: a substrate, a source, a drain, a gate, and a groove. The source, the drain, and the gate are all formed on the substrate, and an active region is formed between the source and the drain on the substrate. The groove is provided in the substrate, and a spacing is formed between the groove and the active region. It may be understood that the groove is formed with a side surface and a bottom surface opposite to the active region, and both the side surface and the bottom surface are spaced from a surface of the active region opposite to the groove. The heat dissipation layer is formed in the groove, and a coefficient of thermal conductivity of the heat dissipation layer is greater than a coefficient of thermal conductivity of the substrate.

In the semiconductor device provided in this embodiment of this application, a groove is provided in a region that is of a substrate and that is located between a source and a drain, and a heat dissipation layer whose coefficient of thermal conductivity is greater than that of the substrate is filled in the groove. In this way, heat of the active region is diffused to the heat dissipation layer in the groove. Compared with the heat diffusion through the substrate, the diffusion efficiency is significantly improved by rapidly diffusing the heat through a heat dissipation layer having a relatively large coefficient of thermal conductivity.

In addition, the groove is provided in the substrate, and both the side surface and the bottom surface of the groove are spaced from the surface of the active region opposite to the groove, that is, the groove does not penetrate to the active region, so that the active region is not damaged, thereby ensuring performance of the semiconductor device.

In a possible implementation of the first aspect, the gate is located between the source and the drain, and a bottom surface of the groove is opposite to the gate.

When the gate is located between the source and the drain, more heat is generated at a position of the active region close to the gate than at other positions. Therefore, the bottom surface of the groove is opposite to the gate, that is, the groove is disposed close to the gate. The heat in the active region close to the gate is diffused to the heat dissipation layer in the groove as soon as possible, and then the heat is quickly dissipated, to improve a heat dissipation effect of the entire semiconductor device.

In a possible implementation of the first aspect, an orthographic projection of the groove on the active region covers an orthographic projection of the gate on the active region.

In this way, not only heat of the substrate close to the gate can be rapidly diffused, but also heat at other positions of the active region can be diffused, thereby further improving the heat dissipation efficiency of the semiconductor device.

In a possible implementation of the first aspect, the source, the drain, and the gate extend in a same direction, and an extending direction of the groove is consistent with an extending direction of the source, the drain, and the gate.

Extending the groove in a direction consistent with the extending direction of the source, the drain, or the gate may increase a filling amount of the heat dissipation material of the heat dissipation layer, and further improve the heat dissipation efficiency.

In a possible implementation of the first aspect, the heat dissipation layer includes: a first heat dissipation layer and a second heat dissipation layer. The first heat dissipation layer is formed on an inner wall surface of the groove, and the second heat dissipation layer is formed on the first heat dissipation layer. The coefficient of thermal conductivity of the first heat dissipation layer is greater than the coefficient of thermal conductivity of the second heat dissipation layer.

The heat dissipation layer is set to the first heat dissipation layer and the second heat dissipation layer, and the first heat dissipation layer having a relatively large coefficient of thermal conductivity is closer to the substrate than the second heat dissipation layer. Further, heat on the substrate is quickly transferred to the first heat dissipation layer, and a heat dissipation effect is improved by using the first heat dissipation layer having a relatively large coefficient of thermal conductivity.

In a possible implementation of the first aspect, the groove including the heat dissipation layer is of a solid structure.

That is, the groove is filled by using the heat dissipation layer. In this way, compared with the fact that a part of the groove is filled by the heat dissipation layer, the heat dissipation efficiency is also improved.

In a possible implementation of the first aspect, the semiconductor device further includes: an epitaxial layer formed on the substrate, a source, a drain, and a gate are all formed on a side of the epitaxial layer far away from the substrate, and a region of the epitaxial layer that is located between the source and the drain forms an active region. When the epitaxial layer is a multi-layer AlxGayN structure, where 0≤x≤1, and 0≤y≤1, the semiconductor device formed is a high electron mobility transistor.

In a possible implementation of the first aspect, the semiconductor device further includes a metal ground layer and a conductive channel. The metal ground layer is disposed on a side of the substrate far away from the source and the drain. The conductive channel runs through the substrate and the epitaxial layer, and connects the source and the metal ground layer.

In a possible implementation of the first aspect, a conductive material filled in the conductive channel is the same as a material of the heat dissipation layer, for example, both may be metal.

The heat dissipation material of the heat dissipation layer is set to be consistent with the conductive material in a conductive through hole. In terms of a manufacturing process, the heat dissipation material is filled in the groove while the conductive material is filled, so as to simplify the manufacturing process.

According to a second aspect, an embodiment of this application further provides a semiconductor device preparation method. The semiconductor device preparation method includes:
providing a groove on a side of the substrate far away from the source, the drain, and the gate, and a spacing is formed between the groove and the active region on the substrate, and also a spacing is formed between the side surface and the bottom surface formed by the groove and a surface opposite to the groove of the active region on the substrate, where the active region formed on the substrate is located between the source and the drain; and
filling the groove with a heat dissipation material to form a heat dissipation layer, where a coefficient of thermal conductivity of the heat dissipation layer is greater than a coefficient of thermal conductivity of the substrate.

In the semiconductor device preparation method provided in embodiments of this application, a groove is first provided in a region that is of a substrate and that is far away from the source, the drain, and the gate and that is located between the source and the drain. In addition, both a side surface and a bottom surface formed by the groove are spaced from a surface opposite to the groove of the active region on the substrate, that is, the provided groove does not penetrate to the active region. Then, a heat dissipation material is filled in the groove to form a heat dissipation layer in the groove, and a coefficient of thermal conductivity of the heat dissipation layer in the groove is greater than a coefficient of thermal conductivity of the substrate. In this way, heat of the active region may be transferred to the heat dissipation layer. In addition, heat dissipation efficiency of the semiconductor device is improved by rapidly diffusing heat of the heat dissipation layer having a relatively large coefficient of thermal conductivity.

In a possible implementation of the second aspect, an epitaxial layer is formed on the substrate, a source, a drain, and a gate are all formed on a side of the epitaxial layer far away from the substrate, and a region of the epitaxial layer that is located between the source and the drain forms an active region.

The preparation method further includes: providing a hole on a side of the substrate far away from the source, the drain, and the gate, so that the hole passes through the substrate and the epitaxial layer and penetrates to the source; and filling the hole with a conductive material to form a conductive channel, and disposing a metal ground layer on a side of the substrate far away from the source, the drain, and the gate, so that the source is connected to the metal ground layer through the conductive channel.

The semiconductor device formed in this way may be a high electron mobility transistor, and a source of the high electron mobility transistor is grounded by using the conductive channel. This helps improve frequency characteristics, such as gain, of the semiconductor device.

In a possible implementation of the second aspect, a hole is provided in the substrate while a groove is provided in the substrate.

That is, the hole and the groove are formed at the same time, which simplifies the manufacturing process.

In a possible implementation of the second aspect, the hole is filled with the conductive material while the groove is filled with the same heat dissipation material as the conductive material.

That is, the conductive material and the heat dissipation material are filled at the same time, and the filled conductive material and the heat dissipation material are the same. In this way, the manufacturing process may be simplified, and manufacturing costs may be reduced.

In a possible implementation of the second aspect, the filling the hole with the conductive material while filling the groove with the same heat dissipation material as the conductive material includes: filling the hole and the groove with metal at the same time, and when the groove is full of metal, forming a metal layer on a wall surface in the hole.

That is, the same metal may be selected for both the heat dissipation material and the conductive material, and when the metal layer is formed on the wall surface in the hole, the groove is full of the metal.

In a possible implementation of the second aspect, the filling the groove with the heat dissipation material includes: filling the groove with a first heat dissipation material, to form a first heat dissipation layer on an inner wall surface of the groove; and filling the groove with the first heat dissipation layer having a second heat dissipation material, to form a second heat dissipation layer on the first heat dissipation layer, and a coefficient of thermal conductivity of the first heat dissipation layer is greater than a coefficient of thermal conductivity of the second heat dissipation layer.

In a possible implementation of the second aspect, the gate is located between the source and the drain. When the groove is provided in the substrate, the method includes: providing the groove in the substrate at a position opposite to the gate.

Because there is more heat at a position close to the gate than at other positions, a heat dissipation effect may be further improved by providing the groove at a position close to the gate.

In a possible implementation of the second aspect, when the groove is provided in the substrate, the method includes: providing a groove in an extending direction of the gate, so that the extending direction of the groove is consistent with an extending direction of the gate.

According to a third aspect, this application further provides an electronic device, including a circuit board and the semiconductor device in any one of the implementations of the first aspect or the semiconductor device prepared in any one of the implementations of the second aspect. The circuit board is electrically connected to the semiconductor device.

The electronic device provided in embodiments of this application includes the semiconductor device prepared in embodiments of the first aspect or embodiments of the second aspect. Therefore, the electronic device provided in embodiments of this application and the semiconductor device in the foregoing technical solutions can resolve a same technical problem and achieve a same expected effect.

### BRIEF DESCRIPTION OF DRAWINGS

FIG. 1 is a schematic structural diagram of an HEMT in a conventional technology;
FIG. 2 is a schematic structural diagram of heat dissipation for an HEMT in a conventional technology;
FIG. 3 is a schematic diagram of a partial structure of an electronic device;
FIG. 4 is a schematic structural diagram of a semiconductor device;
FIG. 5 is a detailed schematic structural diagram of a semiconductor device;
FIG. 6 is a top view of a semiconductor device;
FIG. 7 is a schematic structural diagram of a semiconductor device;
FIG. 8 is a schematic structural diagram of a semiconductor device according to an embodiment of this application;
FIG. 9 is a schematic structural diagram of a semiconductor device according to an embodiment of this application;
FIG. 10 is a schematic structural diagram of a semiconductor device according to an embodiment of this application;
FIG. 11 is a schematic structural diagram of a semiconductor device according to an embodiment of this application;
FIG. 12 is a schematic structural diagram of a semiconductor device according to an embodiment of this application;
FIG. 13 is a top view of a semiconductor device according to an embodiment of this application;
FIG. 14 is a schematic structural diagram of a semiconductor device according to an embodiment of this application;
FIG. 15 is a schematic structural diagram of a semiconductor device according to an embodiment of this application;
FIG. 16 is a top view of a semiconductor device according to an embodiment of this application;
FIG. 17 is an A-A cross-sectional view of FIG. 16;
FIG. 18 is a B-B cross-sectional view of FIG. 16;
FIG. 19 is a top view of a semiconductor device according to an embodiment of this application;
FIG. 20 is a C-C cross-sectional view of FIG. 19;
FIG. 21 is a D-D cross-sectional view of FIG. 19;
FIG. 22 is a top view of a semiconductor device according to an embodiment of this application;
FIG. 23 is an E-E cross-sectional view of FIG. 22;
FIG. 24 is an F-F cross-sectional view of FIG. 22;
FIG. 25 is a top view of a semiconductor device according to an embodiment of this application;
FIG. 26 is an M-M cross-sectional view of FIG. 25;
FIG. 27 is an N-N cross-sectional view of FIG. 25;
FIG. 28 is a flowchart block diagram of a semiconductor device preparation method according to an embodiment of this application; and
FIG. 29 is a schematic structural diagram corresponding to each step in a semiconductor device preparation method according to an embodiment of this application.

### Reference Numerals:

01- PCB; 02 - Chip package structure; 021 - Chip; 022 - Second electrical connection structure; 023 - Package substrate; 03 - First electrical connection structure;
1 - Substrate; 2 - Epitaxial layer; 201 - Nucleating layer; 202 - Buffer layer; 203 - Channel layer; 204 - Barrier layer; 3 - Source; 31 - Source bus; 4 - Gate; 41 - Gate bus; 5 - Drain; 51 - Drain bus; 6 - Metal ground layer; 7- Conductive channel; 8 - Groove; 9 - Heat dissipation layer; 91 - First heat dissipation layer; 92 - Second heat dissipation layer; 10 - Temporary bonding structure; 11 - Carrier; 12 - Hole; 151 - First doped region; 152 - Second doped region; 16 - Insulating layer.

### DESCRIPTION OF EMBODIMENTS

An embodiment of this application provides an electronic device. The electronic device may include a mobile phone (mobile phone), a pad (pad), a smart wearable product (for example, a smartwatch or a smart band), a virtual reality (virtual reality, VR) device, and augmented reality (augmented reality, AR), or may be a server (server), or may be a device such as a data center (data center), and a display (display). A specific form of the foregoing electronic device is not specially limited in this embodiment of this application.

FIG. 3 is a schematic diagram of a partial structure of an electronic device. The mobile phone is used as an example. The electronic device includes a printed circuit board (printed circuit board, PCB) 01 and a chip package structure 02. The chip package structure 02 is electrically connected to the PCB 01 through a first electrical connection structure 03, so that the chip package structure 02 can be interconnected to another chip or another electronic component on the PCB 01. In an optional implementation, the first electrical connection structure 3 may be a ball grid array (ball grid array, BGA).

With reference to FIG. 3, the chip package structure 02 includes: a chip 021 and a package substrate 023, where the chip 021 is integrated on a surface of the package substrate 023, and the chip 021 is disposed on the package substrate 023 through a second electrical connection structure (for example, a metal layer) 022. The chip 021 may perform signal interconnection to another electronic device on the package substrate 023.

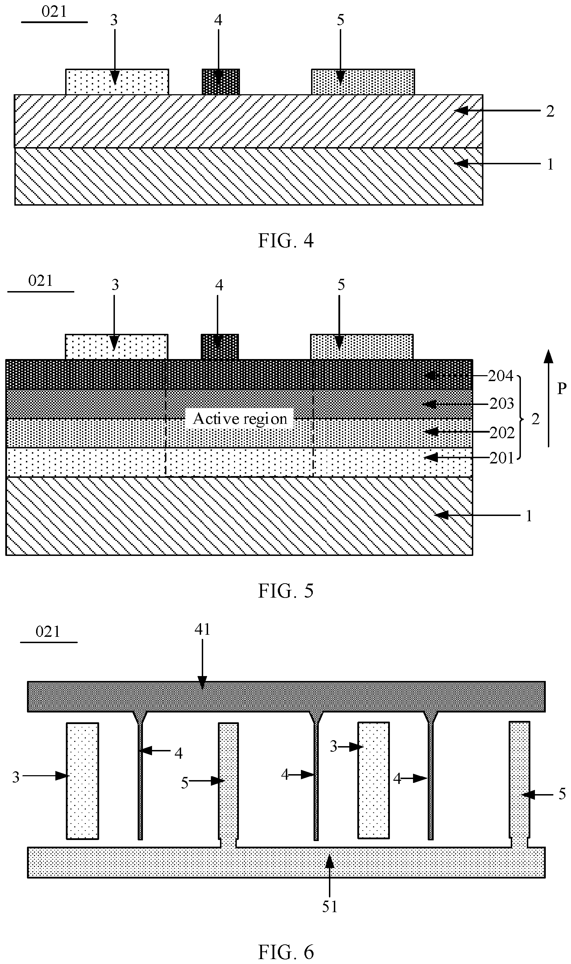

The chip 021 in the electronic device shown in FIG. 3 includes a semiconductor device shown in FIG. 4, and the semiconductor device includes: a substrate 1, an epitaxial layer 2 disposed on a surface of the substrate 1, and a source (Source) 3, a gate (Gate) 4, and a drain (Drain) 5 disposed on a surface of the epitaxial layer 2 far away from the substrate 1.

The substrate 1 may be a silicon carbide (SiC) substrate, a silicon (Si) substrate, a sapphire (Al₂O₃) substrate, or the like. In addition, substrates formed of other materials may be selected.

FIG. 5 is an example of a detailed structural diagram of a semiconductor device in FIG. 4. In the semiconductor device, the epitaxial layer 2 may include a nucleating layer (nucleating layer) 201, a buffer layer 202, a channel layer 203, and a barrier layer 204. The nucleating layer 201, the buffer layer 202, the channel layer 203, and the barrier layer 204 are sequentially stacked on the substrate 1 in a P direction as shown in FIG. 5, and the source 3, the gate 4, and the drain 5 are formed on the barrier layer 204.

In an optional implementation, metal-organic chemical vapor deposition (metal-organic chemical vapor deposition, MOCVD) or molecular beam epitaxy (molecular beam epitaxy, MBE) may be used as growth techniques. The nucleating layer 201, the buffer layer 202, the channel layer 203, and the barrier layer 204 are grown on the substrate 1.

In the semiconductor device shown in FIG. 5, the nucleating layer 201 may be made of gallium nitride (GaN) or aluminum nitride (AlN) or aluminum gallium nitride (AlGaN), or a stack of gallium nitride, aluminum nitride, and aluminum gallium nitride. The buffer layer 202 may be made of GaN or AlGaN, and the channel layer 203 may be made of GaN. When both the buffer layer 202 and the channel layer 203 are made of GaN, the buffer layer 202 of a GaN material is generally doped (for example, doping an element such as carbon or iron) to suppress leakage current. However, the channel layer 203 of a GaN material is configured to route current, and a high-quality and low-impurity GaN epitaxial layer is required.

The barrier layer 204 may be made of AlGaN or aluminum indium nitrogen (AlInN) or an aluminum indium gallium nitrogen (AlInGaN) combined layer. The aluminum content in the barrier layer 204 is different from that in the buffer layer 202 and the channel layer 203, and the source 3, the drain 5, and the gate 4 may be made of any metal or other materials. The semiconductor device formed in this way may be referred to as HEMT.

The barrier layer 204 in FIG. 5 is configured to cooperate with the channel layer 203, to generate a two-dimensional electron gas (two-dimensional electron gas, 2DEG) under the effect of polarization in a region in which the channel layer 203 and the barrier layer 204 are connected, thereby conducting a current.

Further, the source 3 and the drain 5 are used for causing the above-described 2DEG to flow in the channel layer 203 between the source 3 and the drain 5 under an electric field effect, and the gate 4 is disposed between the source 3 and the drain 5. The gate 4 is used for allowing or blocking the passage of 2DEG between the source 3 and the drain 5. Further, an active region is formed between the source 3 and the gate 4 of the epitaxial layer 2. As shown in FIG. 5, a dashed box shows an approximate location of the active region of the semiconductor device.

Based on the foregoing description of the semiconductor device shown in FIG. 5, a high current passes through a region of the channel layer 203 located between the source 3 and the drain 5, and much heat is generated in the region of the active region located between the source 3 and the drain 5. If the heat cannot be diffused in time, a temperature of the active region and the region between the source 3 and the drain 5 of the substrate 1 may rise seriously, thereby deteriorating the performance.

FIG. 5 is only a schematic diagram of a partial structure of the semiconductor device, and FIG. 6 is a partial top view of the semiconductor device. With reference to FIG. 6, the semiconductor device includes a plurality of sources 3, a plurality of gates 4, and a plurality of drains 5. The plurality of gates 4 are connected through a gate bus 41, the plurality of drains 5 are connected through a drain bus 51, and the plurality of sources 3 are connected through another metal layer in the semiconductor device. In this way, a total gate width of the entire semiconductor device may be increased, and a power level may be increased.

When the semiconductor device includes the plurality of sources 3, the plurality of gates 4, and the plurality of drains 5, as shown in FIG. 6, the spacing between adjacent gates 4 and sources 5 is generally about 0.5 µm to 5 µm, and the spacing between the gate 4 and the drain 3 is about 0.5 µm to 15 µm. In this way, a heat accumulation effect is more likely to occur, resulting in rapid temperature increase. If the heat cannot be rapidly dissipated, the electrical performance of the semiconductor device is seriously affected.

In addition, the thermal conductivity of the substrate 1 made of materials such as SiC, Si, and Al₂O₃ becomes poor as the temperature increases. For example, a coefficient of thermal conductivity of the 4H SiC material at room temperature (300 K) is about 350 W/mK, and a coefficient of thermal conductivity is reduced to 200 W/mK at 400 K. The coefficient of thermal conductivity of Si material is about 150 W/mK at room temperature and is reduced to about 100 W/mK at 400 K.

Because a power density of GaN-based HEMT radio frequency device is greater than 6 W/mm, the temperature may easily exceed 400 K during operation. Even if a thickness of the substrate 1 is thinned about 100 µm, the heat dissipation effect of the substrate is poor due to the high temperature during operation. Therefore, in the semiconductor device shown in FIG. 5, heat dissipation in the active region is a key factor that restricts the improvement of the power density of the semiconductor device.

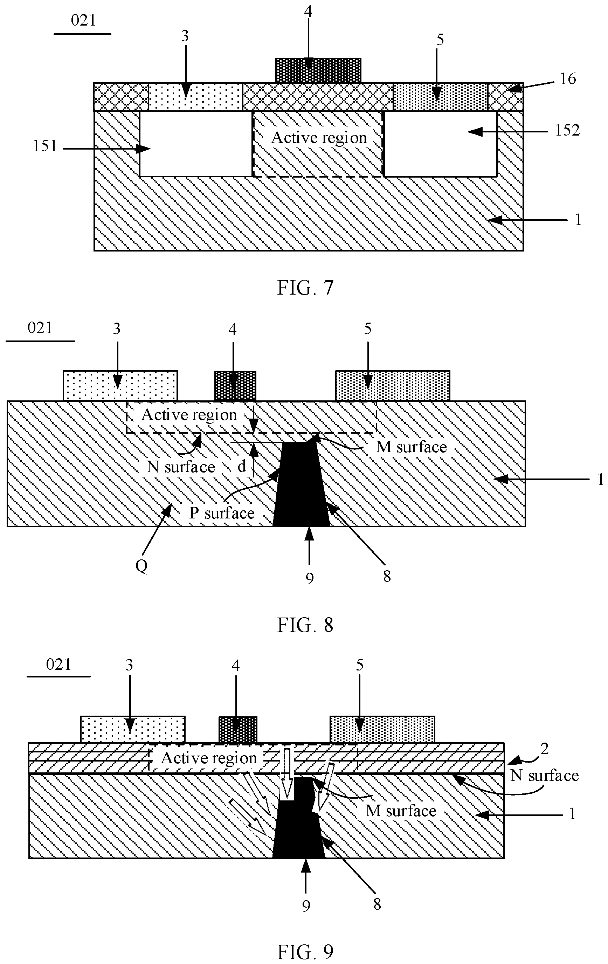

The chip 021 in an electronic device shown in FIG. 3 may also be a semiconductor device shown in FIG. 7. The semiconductor device includes a substrate 1, a first doped region 151 and a second doped region 152 formed in the substrate 1, a source 3 formed on the first doped region 151 and a drain 5 formed on the second doped region 152, and a region of the substrate 1 between the source 3 and the drain 5 forms an active region. As shown in FIG. 7, a dashed box shows an approximate location of the active region of the semiconductor device.

In addition, an insulating layer 16 is provided on the substrate 1, the gate 4 is formed on the insulating layer 16, and the gate 4 is located between the source 3 and the drain 5. The semiconductor device formed in this way may be referred to as a metal-oxide-semiconductor field-effect transistor (metal-oxide-semiconductor field-effect transistor, MOSFET).

With further reference to FIG. 7, the insulating layer 16 may be a silicon dioxide insulating layer, the substrate 1 may be a P-type silicon substrate, and impurity polarities doped (doped) in the first doped region 151 and the second doped region 152 may be N-type. A MOSFET formed in this way may be referred to as an N-channel MOSFET. In some other optional implementations, the substrate 1 may be an N-type silicon substrate, and impurity polarities doped (doped) in the first doped region 151 and the second doped region 152 may be P-type. A MOSFET formed in this way may be referred to as a P-channel MOSFET.

In the semiconductor device shown in FIG. 7, for either an N-channel MOSFET or a P-channel MOSFET, after a channel is formed in the active region, a current passes through. In this way, much heat is generated in the active region. If the heat cannot be diffused in time, the electrical performance of the semiconductor device is also seriously affected.

Therefore, in the semiconductor device shown in FIG. 7, heat dissipation is still a key factor that restricts performance improvement of the semiconductor device.

This application provides a semiconductor device that can improve heat dissipation efficiency. The following describes the semiconductor device in detail with reference to the accompanying drawings.

FIG. 8 is a structural diagram of a semiconductor device according to an embodiment of this application. The semiconductor device includes a substrate 1, a source 3, a gate 4, a drain 5, and an active region formed on the substrate 1 and located between the source 3 and the drain 5. The semiconductor device further includes a groove 8 provided in the substrate 1 and close to the active region, and the groove 8 does not penetrate into the active region, so that the active region is not damaged. In addition, a heat dissipation layer 9 is formed in the groove 8, and a coefficient of thermal conductivity of the heat dissipation layer 9 is greater than a coefficient of thermal conductivity of the substrate 1.

It should be noted that: a coefficient of thermal conductivity (coefficient of thermal conductivity) herein is also referred to as thermal conductivity, and the coefficient of thermal conductivity or the thermal conductivity reflects a thermal conduction capability of a material. It is defined as heat transferred through the unit heat conduction surface per unit time per unit temperature gradient (temperature reduced by 1 K in a length of 1 m).

In the structure shown in FIG. 8, because the groove 8 is provided in the substrate 1 at a position close to the active region, and the substrate 1 is replaced by the heat dissipation layer 9 whose coefficient of thermal conductivity is greater than that of the substrate 1. In this way, the heat dissipated from the active region is conducted to the heat dissipation layer 9, and is quickly diffused by the heat dissipation layer 9 having a relatively large coefficient of thermal conductivity, thereby improving the heat dissipation efficiency of the entire semiconductor device.

The material of the heat dissipation layer 9 has a plurality of choices, for example, a metal such as gold (Au), copper (Cu), nickel (Ni), silver (Ag), tin (Sn), zinc (Zn) may be selected. The coefficient of thermal conductivity of these metals is obviously higher than that of materials such as SiC, Si, and Al2O3 commonly used in the substrate 1. For example, a coefficient of thermal conductivity of Cu is about 400 W/mK at a temperature of 300 K to 500 K. Compared with the Si substrate of 150 W/mK, the coefficient of thermal conductivity of these metals is obviously improved. In addition, the coefficient of thermal conductivity of these metals is slightly attenuated with the increase of temperature, which may significantly improve the temperature of the semiconductor device when the semiconductor device is working at full load, and further improve the power and efficiency of the semiconductor device when the semiconductor device is saturated.

In FIG. 8, the groove 8 is provided close to the active region, and the groove 8 does not penetrate to the active region. In other words, a distance d between a bottom surface of the groove 8 (such as an M surface in FIG. 8) and a surface of the active region opposite to the groove 8 (such as an N surface in FIG. 8) is greater than zero. Further, a distance d between a side surface (such as a P surface in FIG. 8) of the groove 8 and a surface (such as an N surface in FIG. 8) of the active region opposite to the groove 8 is greater than zero. In some optional implementations, the distance d may be 1 µm to 5 µm. The foregoing 1 µm to 5 µm is only an embodiment in which the distance d may be selected. Certainly, the distance d may also be in another value range.

In some optional implementations, the structure of the semiconductor device shown in FIG. 8 may be the HEMT shown in FIG. 9. That is, an epitaxial layer 2 is grown on the substrate 1. The region of the epitaxial layer 2 between the source 3 and the drain 5 is an active region, and the groove 8 is provided in the substrate 1. In this embodiment of this application, that the groove 8 does not penetrate to the active region may refer that the groove 8 does not penetrate to the epitaxial layer 2. In other words, as shown in FIG. 9, a spacing is formed between the bottom surface (M surface) of the groove 8 and the bottom surface (N surface) of the epitaxial layer 2. Then, to improve a heat dissipation effect, the groove 8 may be located below the active region, so as to be closer to the active region and improve the heat dissipation effect. It should be noted that, the epitaxial layer 2 shown in FIG. 9 may be a multi-layer structure shown in FIG. 5.

When the heat dissipation layer 9 whose coefficient of thermal conductivity is larger than that of the substrate 1 is used to cool the HEMT, compared with an existing solution for improving heat dissipation shown in FIG. 2, on the basis of improving heat dissipation efficiency, a size of the semiconductor device is not increased, and a quantity of semiconductor devices cut from a wafer is not reduced.

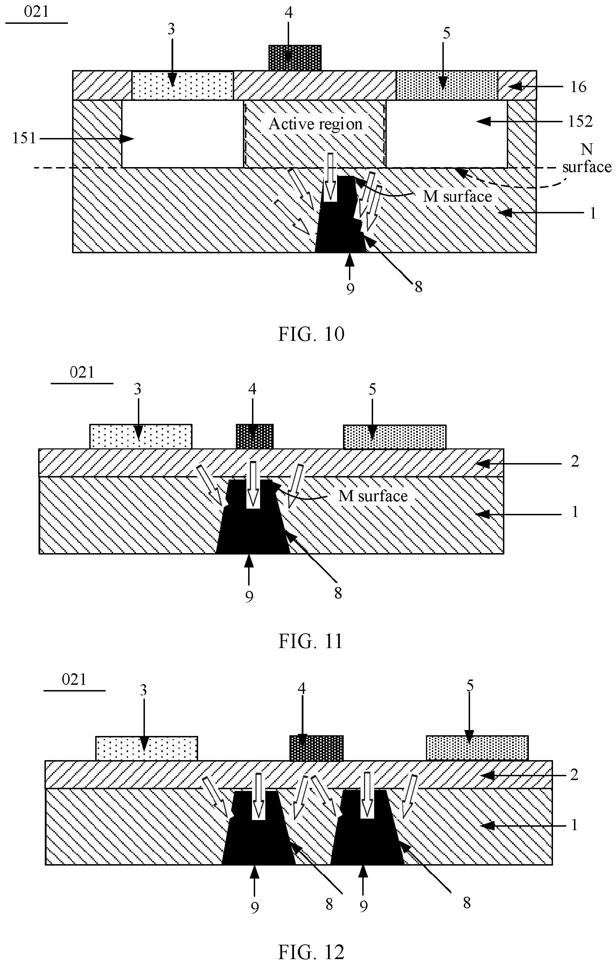

In some other optional implementations, the structure of the semiconductor device shown in FIG. 8 may be the MOSFET shown in FIG. 10. That is, the first doped region 151 and the second doped region 152 are formed by doping impurities in the substrate 1. The region of the substrate 1 between the first doped region 151 and the second doped region 152 is the active region, and the groove 8 is provided in the substrate 1. In this embodiment of this application, that the groove 8 does not penetrate to the active region may refer that the groove 8 does not penetrate to the M surface of the substrate 1. The M surface herein refers to a surface on which the first doped region 151 and the second doped region 152 are located far away from the bottom surface of the source 3 and the drain 5, that is, as shown in FIG. 10, a spacing is formed between the bottom surface (the M surface) and the N surface of the groove 8. In addition, to improve a heat dissipation effect, the groove 8 may be located below the active region between the first doped region 151 and the second doped region 152, so as to be closer to the active region and improve the heat dissipation effect.

In the semiconductor device provided in this embodiment of this application, as shown in FIG. 9 and FIG. 10, the gate 4 is disposed between the adjacent source 3 and the drain 5. In this way, when a current on the drain 5 flows to the source 3 through the active region, alternatively, when a current on the source 3 flows to the drain 5 through the active region, a large resistance is generated at a position close to the gate 4 due to an existence of the gate 4, so that the heat is more and the temperature is higher at a position close to the gate 4 than at other positions. Therefore, as shown in FIG. 11, the bottom surface (the M surface) of the groove 8 is opposite to the gate 4. In this way, a heat dissipation path may be shortened, high heat close to the gate 4 is quickly transferred to the heat dissipation layer 9 in the groove 8, and heat is quickly diffused by the heat dissipation layer with a relatively high coefficient of thermal conductivity.

In some implementations, as shown in FIG. 12, when the spacing between the adjacent source 3 and the gate 2 and the spacing between the adjacent gate 4 and the drain 5 are relatively large, a plurality of grooves 8 may be provided in the substrate 1, and each groove 8 is filled with a heat dissipation layer 9. In this way, a filling amount of the heat dissipation material may be increased, and a heat dissipation effect may be further improved.

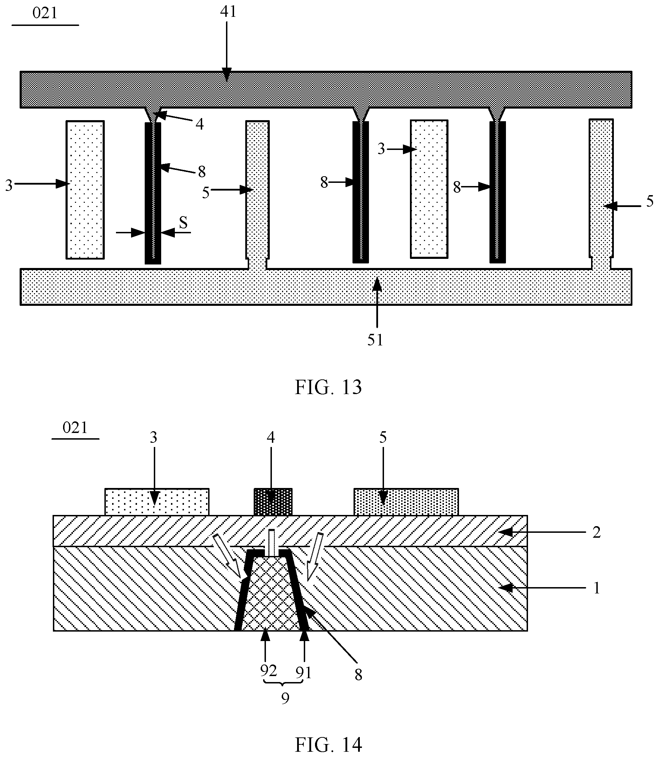

To further improve the heat dissipation efficiency, as shown in FIG. 13, an orthographic projection of the groove 8 on the active region covers an orthographic projection of the gate 4 on the active region. It may also be understood that an outer contour of a vertical projection of the groove 8 on the active region coincides exactly with an outer contour of a vertical projection of the gate 4 on the active region. Alternatively, an outer contour of a vertical projection of the gate 4 on the active region is surrounded by an outer contour of a vertical projection of the groove 8 on the active region. In other words, the groove 8 not only opposites to the gate 4, but also extends in a direction of the source 3 or the drain 5. In this way, not only heat close to the gate 4 is rapidly diffused, but heat close to the source 3 or the drain 5 is also diffused. For example, when the spacing between the adjacent gate 4 and the source 5 is 0.5 µm to 5 µm, the spacing between the gate 4 and the drain 3 is 0.5 µm to 15 µm, and the width of the gate 4 (size S in FIG. 13) is 0.5 µm, the width of the groove 8 (size S in FIG. 13) may be designed to be less than or equal to 20 µm and greater than 0.5 µm.

As shown in FIG. 13, generally, the source 3, the gate 4, and the drain 5 all extend in a same direction. Further, the groove 8 may also extend in a direction consistent with the extending direction of the source 3, the gate 4, and the drain 5, to improve the heat dissipation efficiency.

In some implementations, with reference to FIG. 14, the heat dissipation layer 9 includes a first heat dissipation layer 91 and a second heat dissipation layer 92, where the first heat dissipation layer 91 is formed on a bottom surface and a side surface of the groove 8, and the second heat dissipation layer 92 is formed on the first heat dissipation layer 91. In addition, both a coefficient of thermal conductivity of the first heat dissipation layer 91 and a coefficient of thermal conductivity of the second heat dissipation layer 92 are greater than a coefficient of thermal conductivity of the substrate 1. Further, the coefficient of thermal conductivity of the first heat dissipation layer 91 is greater than the coefficient of thermal conductivity of the second heat dissipation layer 92. The first heat dissipation layer 91 is closer to the substrate 1 than the second heat dissipation layer 92. In this way, heat may be quickly diffused by the first heat dissipation layer 91 having a relatively higher coefficient of thermal conductivity, so that the heat dissipation efficiency may be further improved, and a temperature close to the active region of the semiconductor device may be significantly reduced.

A material with a high coefficient of thermal conductivity, such as a diamond film or graphene, may be selected as a material of the first heat dissipation layer 91 herein. In addition, the material may further be in good contact with the substrate 1 (for example, silicon), thereby improving connection strength between the entire heat dissipation layer and the groove.

The groove 8 including the heat dissipation layer 9 may be a solid structure or a void structure. The solid structure herein may also be a structure close to solid, that is, there may also be a small gap inside the heat dissipation layer 9. In the void structure, the heat dissipation layer 9 may be formed on a wall surface of the groove 8.

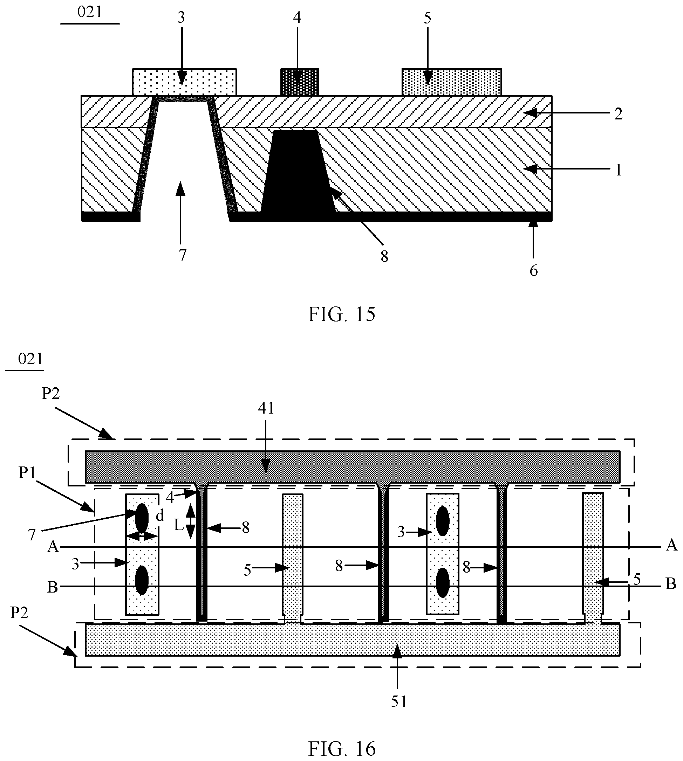

When the semiconductor device provided in this embodiment of this application is an HEMT, the source 3 needs to be grounded. In some optional implementations, the source 3 is grounded through a lead. In some other optional implementations, as shown in FIG. 15, a metal ground layer 6 is formed on a side of the substrate 1 far away from the epitaxial layer 2, and a conductive channel 7 directly connected to the source 3 is provided in the substrate 1 and the epitaxial layer 2, so that the source 3 is connected to the metal ground layer 6, and the source 3 is grounded.

As shown in FIG. 15, if the semiconductor device includes a conductive channel 7 and a groove 8 having a heat dissipation layer 9, to simplify a manufacturing process and reduce manufacturing costs, a material of the heat dissipation layer 9 may be the same as a conductive material in the conductive channel 7, for example, metal is selected for both. The metal may be gold (Au), copper (Cu), nickel (Ni), silver (Ag), tin (Sn), zinc (Zn), or the like, or may be different combinations of these metals.

In addition, when a through hole of the conductive channel is provided, the groove 8 may be provided at the same time. When the through hole is filled with metal, the groove 8 may be filled with metal at the same time.

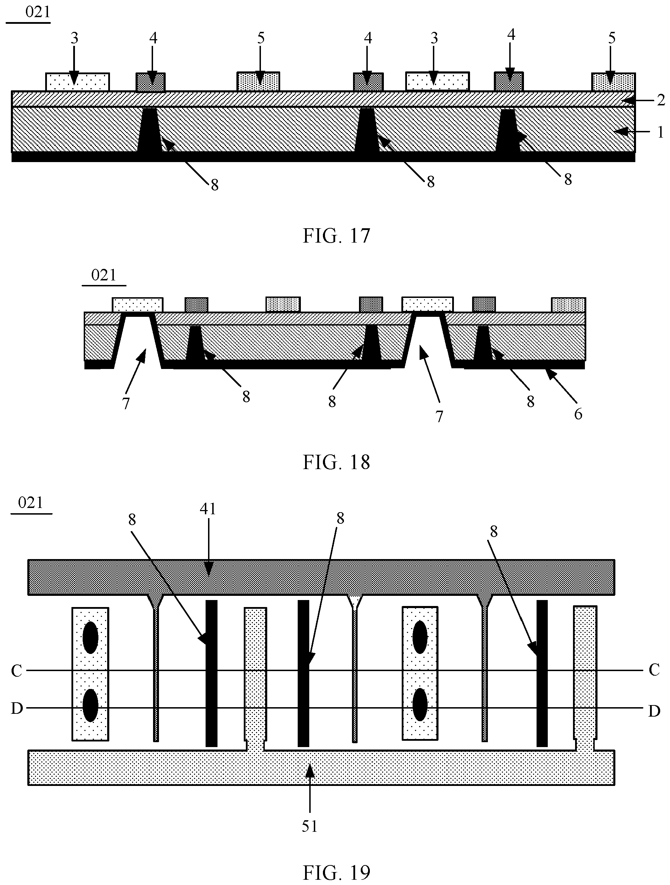

FIG. 16 is a top view of a HEMT with side-by-side electrodes, FIG. 17 is a cross-sectional view of A-A of FIG. 16, and FIG. 18 is a cross-sectional view of B-B of FIG. 16.

In FIG. 16, a position in which the corresponding plurality of sources 3, the plurality of gates 4, and the plurality of drains 5 of the epitaxial layer 2 are located is referred to as an active region P1. Because there is a relatively high current passing through the region, the region is referred to as the active region. On the contrary, the region in which the corresponding gate bus 41 and drain bus 51 of the epitaxial layer 2 are located may be referred to as a passive region P2 because no large current passes through the region.

In the HEMT shown in FIG. 16, the conductive channel 7 is provided at the source 3 of the active region P1. In this way, a transmission path from the source 3 to the metal ground layer 6 may be shortened, a resistance may be reduced, and a loss may be reduced.

In addition, to reduce the inductance of the source 3, the size of the conductive channel 7 is expected to be as large as possible. However, because the width of the source 3 (size d in FIG. 16) is limited, a cross section of the conductive channel 7 is close to an elliptical structure. That is, the cross section of the conductive channel is stretched in the extending direction of the source. For example, a minor axis size of the elliptical structure may be greater than 25 µm, to reduce the source resistance when it is ensured that the conductive channel has relatively good conductivity.

In some optional implementations, in FIG. 16, each source 3 correspondingly has a plurality of conductive channels 7 that are arranged at intervals in the extending direction of the source.

With reference to FIG. 16, a groove 8 is provided at a position of the substrate 1 close to the gate 4, and an orthographic projection of the groove 8 on the epitaxial layer 2 covers an orthographic projection of the gate 4 on the epitaxial layer 2. Further, a length size of the groove 8 is similar to a width size of the gate 4 (which may be slightly greater or less than a width of the gate 4). The width of the gate 4 herein refers to a size of each gate 4 in an L direction in FIG. 16.

To further improve a heat dissipation effect, a groove filled with a heat dissipation layer may also be disposed at a position that is of the substrate 1 of the passive region P2 and that is close to the gate bus 41.

As shown in FIG. 18, a groove 8 is provided at a position directly below each gate 4 of the substrate 1, and each groove 8 is filled with a heat dissipation layer. In this way, even if a distance between two adjacent gates is relatively close, heat accumulation is correspondingly reduced, to effectively reduce a temperature of the heat source region.

As shown in FIG. 18, both the conductive material in the conductive channel 7 and a material of the heat dissipation layer 9 may be metal, and the heat dissipation layer 9 made of the metal material is integrally connected to the metal ground layer 6.

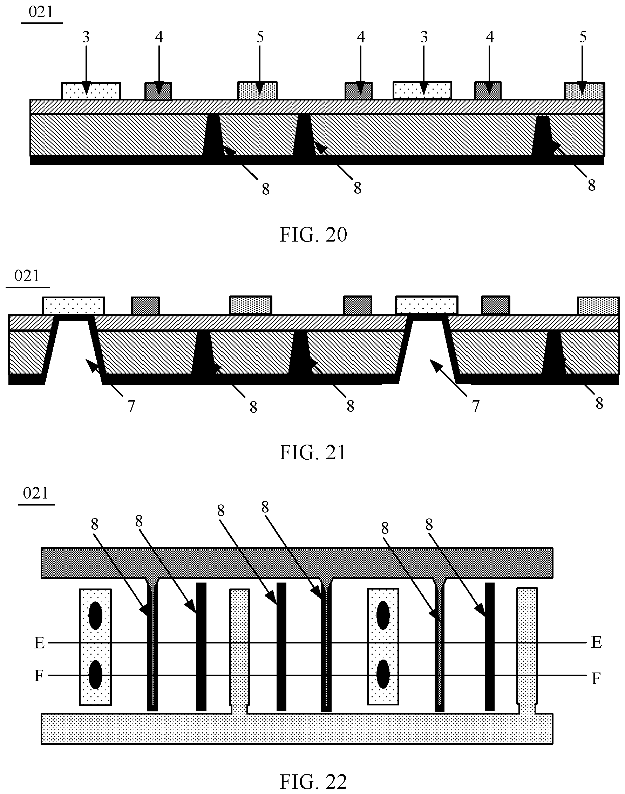

FIG. 19 is a top view of another HEMT with side-by-side electrodes, FIG. 20 is a cross-sectional view of C-C of FIG. 19, and FIG. 21 is a cross-sectional view of D-D of FIG. 19.

The difference between the HEMT shown in FIG. 19 to FIG. 21 and the HEMT shown in FIG. 16 to FIG. 18 is as follows: The groove 8 is located between the gate 4 and the drain 5 of the substrate 1. Similarities are as follows: As shown in FIG. 17, the conductive channel 7 is connected to the source 3 of the active region and the metal ground layer.

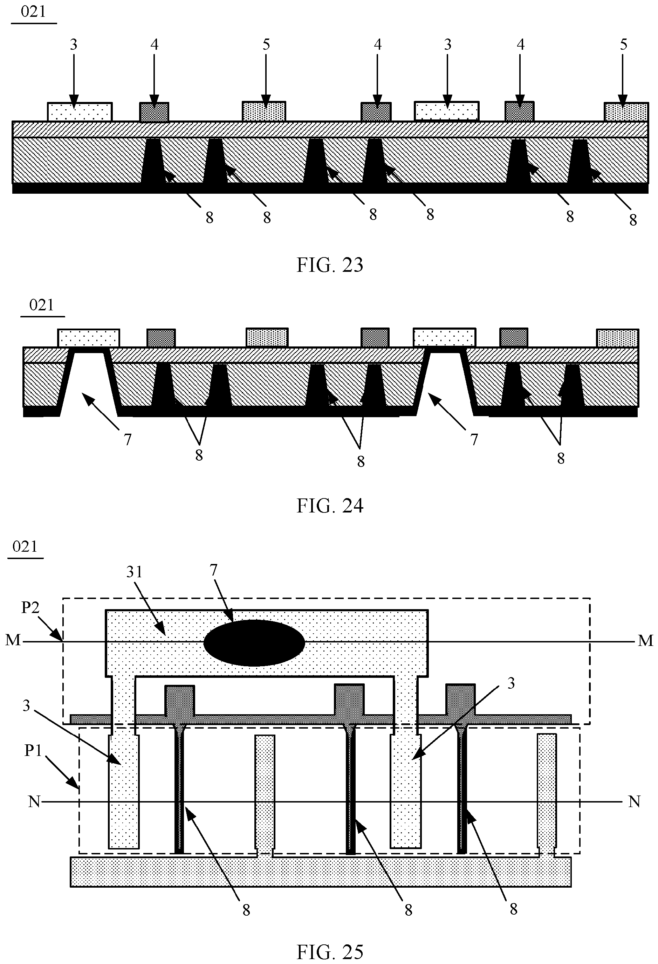

FIG. 22 is a top view of another HEMT with side-by-side electrodes, FIG. 23 is a cross-sectional view of E-E of FIG. 22, and FIG. 24 is a cross-sectional view of F-F of FIG. 22.

In this embodiment, the conductive channel 7 is connected to the source 3 of the active region and the metal ground layer, the groove 8 is provided at a position of the substrate close to the gate, and the groove 8 is also provided between the gate 4 and the drain 5 of the substrate.

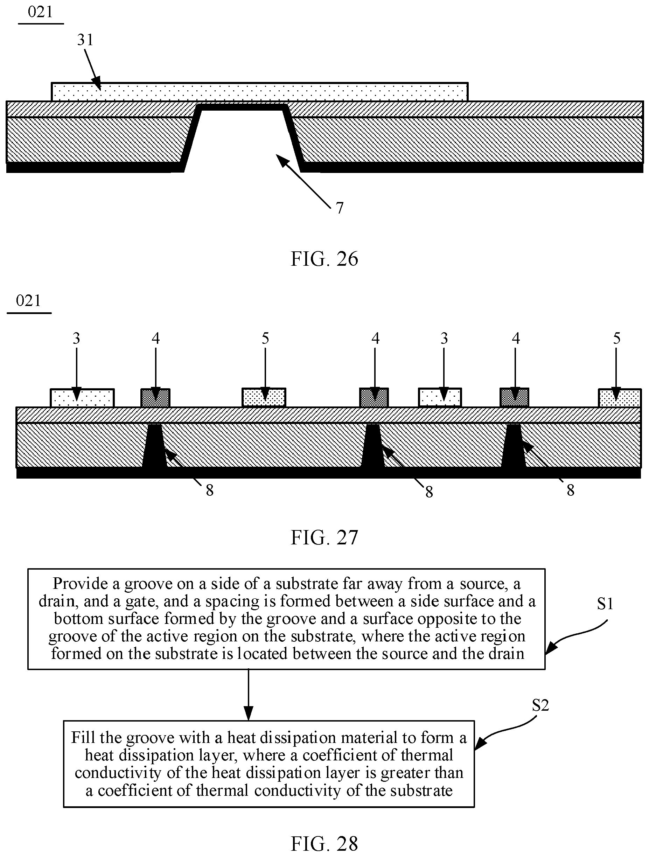

FIG. 25 is a top view of another HEMT with side-by-side electrodes, FIG. 26 is a cross-sectional view of M-M of FIG. 25, and FIG. 27 is a cross-sectional view of N-N of FIG. 25.

In this embodiment, as shown in FIG. 25, the conductive channel 7 is provided on the source bus 31 located in the passive region P2, so that the conductive channel 7 does not occupy a space of the active region P1 (which saves an area of the HEMT and reduces the cost of a single HEMT), and a conductive channel 7 is disposed in the passive region P2. The size of the conductive channel 7 may be flexibly designed. To reduce the inductance of the source, a size of the conductive channel located in the passive region may be designed to be relatively large, for example, a minor axis size of the conductive channel with an elliptical cross-section is generally greater than 50 µm. When a thickness of the metal layer in the conductive channel is the same, the conductive channel with a larger hole has a lower resistance.

With reference to FIG. 27, a groove 8 is provided at a position of the substrate 1 close to each gate 4, and a heat dissipation layer is filled in each groove 8.

Embodiments of this application further provide a semiconductor device preparation method. With reference to FIG. 28, the preparation method includes the following steps.

S1: Provide a groove on a side of the substrate far away from the source, the drain, and the gate, and a spacing is formed between a side surface and a bottom surface formed by the groove and a surface opposite to the groove of the active region on the substrate, where the active region formed on the substrate is located between the source and the drain.

That is, the groove is only provided in the substrate, and does not penetrate into the active region, so that performance of the active region is not affected.

S2: Fill the groove with a heat dissipation material to form a heat dissipation layer, where a coefficient of thermal conductivity of the heat dissipation layer is greater than a coefficient of thermal conductivity of the substrate.

In the semiconductor device prepared by the foregoing step S1 and step S2, even if the active region has a large amount of heat, the heat may be quickly diffused by a heat dissipation layer having a relatively large coefficient of thermal conductivity. Compared with a substrate having a relatively low coefficient of thermal conductivity, the heat dissipation efficiency may be obviously improved. Therefore, the semiconductor device prepared by the method does not restrict an increase of the power density due to heat dissipation.

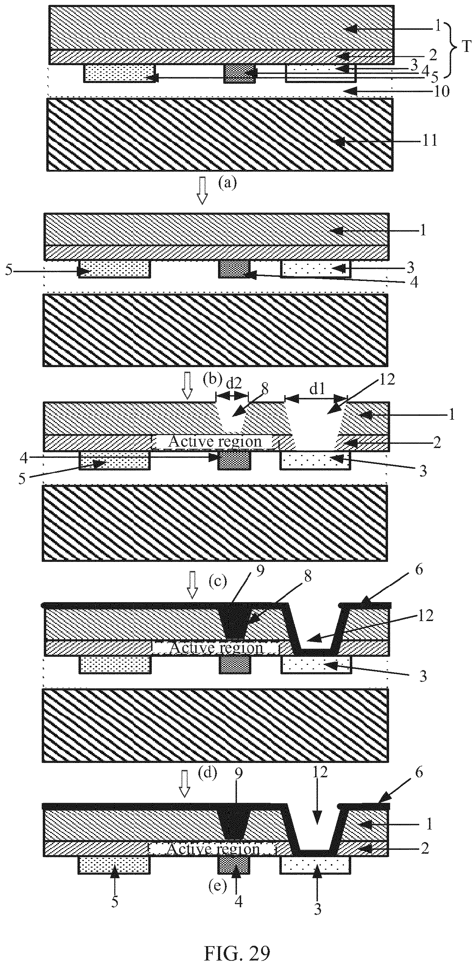

When the semiconductor device is an HEMT, the following provides an HEMT preparation method. A source of the prepared HEMT is connected to a metal ground layer through a conductive channel, so that the source is grounded. The HEMT preparation method is described in detail below with reference to FIG. 29.

As shown in (a) of FIG. 29, a semiconductor device T including a substrate 1, an epitaxial layer 2, a source 3, a gate 4, and a drain 5 is carried on a carrier 11 through a temporary bonding structure 10. The source 3, the gate 4, and the drain 5 face toward the carrier 11.

The temporary bonding structure 10 herein may be an adhesive layer or another connection structure.

The carrier 11 herein may be a wafer, a glass substrate, or the like.

As shown in (b) of FIG. 29, a back surface of the substrate 1 far away from the epitaxial layer 2 is thinned, for example, the thickness of the substrate 1 is thinned to 50 µm to 150 µm.

When thinning the substrate, a grinding wheel thinning process, a grinding process, or a chemical mechanical polishing (chemical mechanical polishing, CMP) process may be used.

As shown in (c) of FIG. 29, a groove 8 is provided in the substrate 1, and the groove 8 is close to the active region between the source and the drain. In addition, a hole 12 is provided in the substrate 1 at a position close to the source, and the hole 12 penetrates through the substrate 1 and the epitaxial layer 2 to the source.

The groove 8 and the hole 12 herein may be formed by photolithography and etching processes.

It should be noted that, the hole 12 and the groove 8 may be formed by etching at the same time, or one of the hole 12 and the groove 8 may be etched first and then the other. When the hole and the groove are formed at the same time, a process procedure of the semiconductor device may be shortened and the process steps may be simplified.

If the hole 12 and the groove 8 are etched at the same time, a size of the groove may be designed to be smaller than a size of the hole, for example, when a minor axis (d1 in FIG. 29) of the hole with an elliptical cross-sectional structure is greater than 25 µm, a width of the groove (d2 of FIG. 29) is less than 20 microns. In this way, when the hole 12 is etched to the source metal layer, the groove 8 are also close to the epitaxial layer 2, so that the hole and the groove are completed at the same time.

When the hole 12 and the groove 8 are etched by using the etching process, the closer the hole 12 and the groove 8 are to the epitaxial layer, the smaller the opening size, so that the side wall surface is an inclined surface. However, specific shapes of the hole and the groove are not specifically limited in this application.

As shown in (d) of FIG. 29, the hole 12 is filled with a conductive material to form a conductive channel, and the groove 8 is filled with a heat dissipation material to form a heat dissipation layer 9.

Similarly, the hole may be filled with a conductive material, and the groove may be filled with a heat dissipation material. To simplify the process, a metal may be used as a conductive material and a heat dissipation material. In this way, a metal 13 may be filled in both the hole and the groove.

In some implementations, when a minor axis of the hole 12 with an elliptical cross-sectional structure is greater than 25 µm, a width (d2 in FIG. 29) of the groove 8 is less than 20 microns, and if a metal layer with a thickness of 2 µm to 8 µm is formed on the side wall surface of the hole, the groove 8 is also substantially full of metal.

As shown in (d) of FIG. 29, the groove 8 may be first filled with a material with a coefficient of thermal conductivity higher than a coefficient of thermal conductivity of a metal, for example, a diamond film or graphene, to form a first heat dissipation layer on an inner wall surface of the groove 8. Then, the hole and the groove having the first heat dissipation layer are filled with metal at the same time, to form a second heat dissipation layer made of metal on the first heat dissipation layer.

It should be noted that, when filling the groove with a material with a coefficient of thermal conductivity higher than that of a metal, a material with a filling temperature not exceeding 500°C needs to be selected. If a material with a filling temperature exceeding 500°C is used, irreversible damage is caused to the device.

When filling metal, physical vapor deposition (Physical vapor deposition, PVD), chemical vapor deposition (chemical vapor deposition, CVD), electro-chemical deposition (Electro-chemical deposition, ECD) may be selected. In this way, a metal ground layer is formed on a surface of the substrate 1 far away from the epitaxial layer 2.

As shown in (e) of FIG. 29, a carrier is unbonded to obtain a semiconductor device shown in (e) of FIG. 29.

Therefore, when the HEMT is prepared by using the method shown in FIG. 29, compared with the conventional technology, the process does not change greatly, and has good compatibility with the conventional technology.

In the descriptions of this specification, the specific features, structures, materials, or characteristics may be combined in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor device, comprising:
a substrate;
a source, a drain, and a gate, wherein the source, the drain, and the gate are all formed on the substrate, and an active region is formed between the source and the drain on the substrate;
a groove, provided in the substrate, wherein a spacing is formed between the groove and the active region; and
a heat dissipation layer, formed in the groove, wherein a coefficient of thermal conductivity of the heat dissipation layer is greater than a coefficient of thermal conductivity of the substrate.

2. The semiconductor device according to claim 1, wherein the gate is located between the source and the drain, and the groove is opposite to the gate.

3. The semiconductor device according to claim 1 or 2, wherein an orthographic projection of the groove on the active region covers an orthographic projection of the gate on the active region.

4. The semiconductor device according to any one of claims 1 to 3, wherein the source, the drain, and the gate extend in a same direction, and an extending direction of the groove is consistent with an extending direction of the source, the drain, and the gate.

5. The semiconductor device according to any one of claims 1 to 4, wherein the heat dissipation layer comprises:
a first heat dissipation layer and a second heat dissipation layer, wherein
the first heat dissipation layer is formed on a bottom surface and a side surface of the groove, and the second heat dissipation layer is formed on the first heat dissipation layer; and
a coefficient of thermal conductivity of the first heat dissipation layer is greater than a coefficient of thermal conductivity of the second heat dissipation layer.

6. The semiconductor device according to any one of claims 1 to 5, wherein the groove comprising the heat dissipation layer is of a solid structure.

7. The semiconductor device according to any one of claims 1 to 6, wherein the semiconductor device further comprises:
an epitaxial layer formed on the substrate, wherein the source, the drain, and the gate are all formed on a side of the epitaxial layer far away from the substrate, and a region of the epitaxial layer that is located between the source and the drain forms the active region.

8. The semiconductor device according to claim 7, wherein the semiconductor device further comprises:
a metal ground layer, disposed on a side of the substrate far away from the epitaxial layer; and
a conductive channel, running through the substrate and the epitaxial layer, and connecting the source and the metal ground layer.

9. The semiconductor device according to claim 8, wherein a conductive material filled in the conductive channel is the same as a heat dissipation material filled in the heat dissipation layer.

10. The semiconductor device according to claim 9, wherein both the conductive material and the heat dissipation material are metal.

11. A semiconductor device preparation method, comprising:
providing a groove on a side of a substrate far away from a source, a drain, and a gate, wherein a spacing is formed between the groove and an active region on the substrate, and the active region is formed on the substrate and located between the source and the drain; and
filling the groove with a heat dissipation material to form a heat dissipation layer, wherein a coefficient of thermal conductivity of the heat dissipation layer is greater than a coefficient of thermal conductivity of the substrate.

12. The semiconductor device preparation method according to claim 11, wherein an epitaxial layer is formed on the substrate, wherein the source, the drain, and the gate are all formed on a side of the epitaxial layer far away from the substrate, and a region of the epitaxial layer that is located between the source and the drain forms the active region; and
the preparation method further comprises:
providing a hole on a side of the substrate far away from the epitaxial layer, so that the hole passes through the substrate and the epitaxial layer and penetrates to the source; and
filling the hole with a conductive material to form a conductive channel, and disposing a metal ground layer on the side of the substrate far away from the epitaxial layer, so that the source is connected to the metal ground layer through the conductive channel.

13. The semiconductor device preparation method according to claim 12, comprising:
providing the hole in the substrate while providing the groove in the substrate.

14. The semiconductor device preparation method according to claim 12 or 13, comprising: filling the hole with the conductive material while filling the groove with the same heat dissipation material as the conductive material.

15. The semiconductor device preparation method according to claim 14, wherein the filling the hole with the conductive material while filling the groove with the same heat dissipation material as the conductive material comprises:
when both the hole and the groove are filled with metal, and the groove is full of the metal, a metal layer is formed on a wall surface in the hole.

16. The semiconductor device preparation method according to any one of claims 11 to 15, wherein when the groove is filled with the heat dissipation material, the method comprises:
filling the groove with a first heat dissipation material, to form a first heat dissipation layer on a bottom surface and a side surface of the groove; and
filling the groove having the first heat dissipation layer with a second heat dissipation material, to form a second heat dissipation layer on the first heat dissipation layer, wherein a coefficient of thermal conductivity of the first heat dissipation layer is greater than a coefficient of thermal conductivity of the second heat dissipation layer.

17. The semiconductor device preparation method according to any one of claims 11 to 16, wherein the gate is located between the source and the drain; and
when the groove is provided in the substrate, the method comprises: providing the groove in the substrate at a position opposite to the gate.

18. The semiconductor device preparation method according to any one of claims 11 to 17, wherein when the groove is provided in the substrate, the method comprises: providing the groove in an extending direction of the gate, so that an extending direction of the groove is consistent with the extending direction of the gate.

19. An electronic device, comprising:
a circuit board; and
the semiconductor device according to any one of claims 1 to 10, or the semiconductor device prepared by using the semiconductor device preparation method according to any one of claims 11 to 18, wherein the circuit board is electrically connected to the semiconductor device.
